# FASCICULE DE BREVET EUROPEEN

(11) **EP 0 453 371 B1**
(45) Date de publication et mention de la délivrance du brevet: **08.07.1998**
(21) Numéro de dépôt: 91401035.0
(22) Date de dépôt: 18.04.1991
(51) Int. Cl.: G06F 9/44

(54) **Procédé interactif de production de logiciel en code source modélisant un ensemble complexe de modules fonctionnels**
Interaktives Verfahren zur Erzeugung von Software-Quellkode, der eine komplexe Menge von funktionalen Modulen modelliert
Interactive procedure for producing software source code modelling a complex set of functional modules

(30) Priorité: 20.04.1990 FR 9005068
(43) Date de publication de la demande: 23.10.1991
(73) Titulaire: AEROSPATIALE Société Nationale Industrielle, 75781 Paris Cédex 16 (FR)
(72) Inventeur: Galy, Paul, F-31100 Toulouse (FR); Giacometti, Jean-Patrice, F-31000 Toulouse (FR); Tocaven, Christian, F-31170 Tournefeuille (FR); Boulicault, Gérard, F-31520 Ramonville (FR)
(74) Mandataire: Dubois-Chabert, Guy

(56) Documents cités:
- PROCEEDINGS of the IEEE/AIAA 7th DIGITAL AVIONICS SYSTEMS CONFERENCE, Fort Worth, Texas, 13-16 octobre 1986, pages 196-203; D.D.MORTON: 'A graphics oriented design language for control software'
- Proceedings of The IEEE 1986 National Aerospace and Electronics Conference NAECON 1986, Dayton Convention Center, 19-23 mai 1986, vol. 3/4, pages 656-663; Peter GOEHNER: 'Integrated computer support for software/hardware systems development'
- PROCEEDINGS of the THIRD SYMPOSIUM ON COMPUTERAIDED CONTROL SYSTEM DESIGN (CACSD), Arlington, Virginia, 24-26 septembre 1986, pages 37-41; L.L. LEHMAN et al.: 'Automated Synthesis of Ada Real-Time Control Software'
- Notice commerciale de la Société ASSIGRAPH INTERNATIONAL
- P. Brard: "Dessin et conception de schémas électriques assistés par ordinateur

## Description

La présente invention concerne un procédé interactif de production de logiciel en code source, modélisant un ensemble complexe de modules fonctionnels.

Elle s'applique à la simulation et à la conception d'ensembles fonctionnels complexes, tels que des systèmes de commande de sécurité dans des centrales nucléaires, des systèmes de commande de machines outils robotisées...etc.

Elle s'applique avantageusement à la simulation et à la conception de modules fonctionnels, tels que des automates ou des circuits logiques complexes de commandes électriques ou automatiques de vol d'un avion.

Dans cette application, le procédé de l'invention permet de concevoir graphiquement puis, par une opération automatique de traduction, d'obtenir dans un langage ou code source, le logiciel modélisant les modules fonctionnels des commandes de vol de l'avion. Lorsque ce logiciel a été établi, il est ensuite utilisé dans un simulateur de vol pour tester les commandes de vol électriques ou automatiques simulées dans différentes conditions de vol. En fonction des résultats de ces tests, la conception graphique est modifiée de façon interactive comme on le montrera plus loin en détail. Lorsque les résultats des tests sont satisfaisants, après ces modifications, le code source peut être compilé pour obtenir alors un logiciel en code exécutable qui peut alors être enregistré dans la mémoire du calculateur de bord de l'avion, pour commander les modules fonctionnels constitués d'automates ou de circuits logiques agissant sur le vol de l'avion.

On ne connaît pas actuellement de procédé de production de logiciel en code source à partir de planches graphiques, capable de modéliser un ensemble complexe de modules fonctionnels, pouvant être modifié très rapidement de manière interactive en fonction des résultats des tests de simulation de cet ensemble fonctionnel, dans différentes conditions de fonctionnement.

On sait seulement modéliser en code source, pour un module fonctionnel, des planches graphiques correspondant aux parties fonctionnelles de ce module. Toutefois, lorsque toutes les planches ont été traduites en code source, la modification de l'une de ces planches, à la suite de tests par exemple, rend actuellement nécessaire une nouvelle traduction en code source de la planche modifiée, mais aussi une nouvelle traduction en code source de toutes les autres planches du module. Il est ensuite nécessaire de vérifier la cohérence fonctionnelle de chaque planche ainsi retraduite.

De façon connue, pour modéliser une partie fonctionnelle d'un module on met en oeuvre, dans un ordinateur relié à des moyens de visualisation, un logiciel d'édition graphique enregistré dans une mémoire reliée à l'ordinateur, pour élaborer, pour des parties fonctionnelles de ce module (des asservissements ou des circuits logiques par exemple), des planches graphiques correspondant respectivement à ces parties fonctionnelles. Ces planches sont affichées par des moyens de visualisation et elles sont élaborées à partir d'une bibliothèque de symboles graphiques correspondant à des éléments fonctionnels de chaque planche. Cette bibliothèque est enregistrée dans la mémoire de l'ordinateur et permet de décrire les asservissements et/ou circuits logiques de chaque planche.

Ce logiciel d'édition est par exemple un logiciel "SAFIRS" commercialisé par la société ASSIGRAPH International.

Cette édition graphique étant effectuée, on sait aussi mettre en oeuvre dans l'ordinateur un logiciel de précodage, enregistré dans la mémoire de l'ordinateur, pour définir chaque symbole d'une planche par un précode comportant au moins les attributs qualificatifs du symbole et les variables d'entrée-sortie de ce symbole. Chaque symbole représente en effet un élément fonctionnel ayant au moins une entrée et au moins une sortie. Toute variable ou paramètre caractéristique d'un signal appliqué en entrée correspond à une variable ou paramètre caractéristique d'un signal recueilli en sortie, en réponse à ce signal d'entrée.

Ce précodage est réalisé, de manière connue, à partir d'une bibliothèque de précodes enregistrée dans la mémoire de l'ordinateur. Pour chaque planche, un fichier de précodage des symboles de la planche est enregistré dans la mémoire de l'ordinateur, après que ce précodage ait été effectué.

Un précodage tel que décrit est par exemple réalisé par un logiciel "SCALP" de la Société AEROSPATIALE, commercialisé par la Société ASSIGRAPH International.

Dans l'état actuel de la technique, la modélisation d'un module fonctionnel consiste donc seulement à modéliser séparément, sous forme de logiciels exprimés en code source, des planches graphiques correspondant respectivement à des parties fonctionnelles de ce module, sans établir de lien ou de vérification de cohérence entre les logiciels de modélisation de ces différentes planches.

Cette absence de lien et de vérification de cohérence est un inconvénient important puisqu'il en résulte qu'il est impossible de disposer rapidement d'un logiciel unique et fiable de modélisation de l'ensemble d'un module.

L'invention a précisément pour but de remédier à ces inconvénients en établissant des liens et des vérifications de cohérence entre les logiciels de modélisation de différentes planches d'éléments fonctionnels d'un module.

L'invention concerne un procédé interactif de production de logiciel en code source, modélisant des ensembles complexes de modules fonctionnels, selon la revendication 1.

Selon une autre caractéristique, le procédé consiste à modéliser des ensembles complexes de modules de commandes électriques ou automatiques de vol d'un avion.

Les caractéristiques et avantages de l'invention ressortiront mieux de la description qui va suivre, donnée en référence aux dessins annexés dans lesquels :
- la figure 1 représente schématiquement un système permettant de mettre en oeuvre le procédé de l'invention ;
- la figure 2 représente schématiquement les logiciels, fichiers, dictionnaire et bibliothèque enregistrés dans une mémoire d'un ordinateur du système de la figure précédente, et qui sont mis en oeuvre dans le procédé de l'invention.

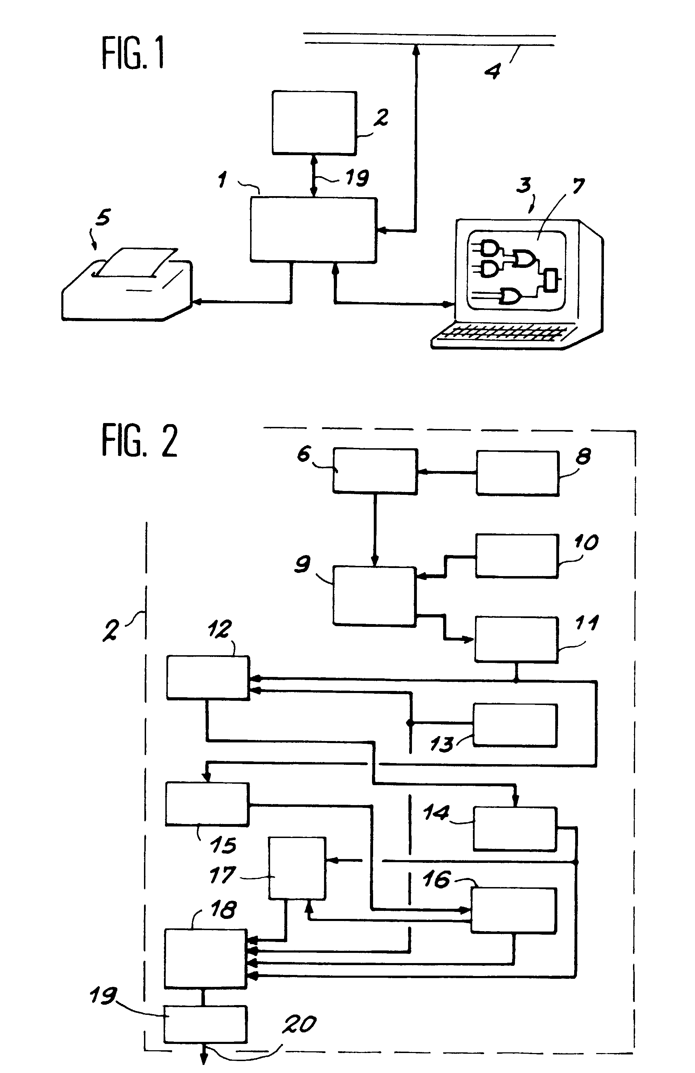

Le système représenté schématiquement sur la figure 1, et qui permet de mettre en oeuvre le procédé de l'invention, comporte un ordinateur 1, une mémoire 2 reliée à cet ordinateur et des moyens de visualisation 3, tels qu'un terminal à écran. L'ordinateur 1 est relié à un réseau de communications 4, pour des raisons qui seront expliquées ultérieurement. Le système peut aussi comporter une imprimante 5 permettant par exemple d'imprimer des résultats résultant de la mise en oeuvre du procédé.

La figure 2 permet de mieux comprendre le procédé de l'invention et représente de manière schématique le contenu de la mémoire 2, lors de la mise en oeuvre du procédé.

Le procédé consiste tout d'abord à mettre en oeuvre, dans l'ordinateur 1, un logiciel 6 d'édition graphique, enregistré dans la mémoire 2. Ce logiciel permet d'élaborer des planches graphiques, telles que la planche 7 affichée sur l'écran des moyens de visualisation 3. Ces planches, comme indiqué plus haut, décrivent des asservissements et/ou des circuits logiques d'un module fonctionnel complexe tel qu'un module de commandes électriques ou automatiques de vol dans un avion.

Le logiciel d'édition 6 élabore ces planches, à partir d'une bibliothèque 8 de référence de symboles graphiques enregistrés dans la mémoire 2. Ces symboles permettent de décrire, dans un ensemble de planches, les asservissements et/ou circuits logiques du module. Ce logiciel qui peut être le logiciel "SAFIRS" cité plus haut, ne sera pas décrit ici en détail.

Le procédé consiste ensuite à mettre en oeuvre, dans l'ordinateur 1, un logiciel 9 de précodage, enregistré dans la mémoire 2 et permettant de définir chaque symbole d'une planche par un précode. A cet effet, la mémoire 2 contient une bibliothèque 10 de précodes. Le précode d'un symbole comporte des informations concernant les attributs du symbole (c'est-à-dire la nature de ce symbole) et des informations concernant des variables d'entréesortie, c'est-à-dire des paramètres caractéristiques de signaux d'entrée et de sortie de l'élément fonctionnel qui, dans le module, correspond à ce symbole. Un fichier 11 de précodage est alors enregistré pour chaque planche, dans la mémoire 2, pour l'ensemble des symboles de la planche.

Le logiciel de précodage, qui peut être par exemple le logiciel "SCALP" cité plus haut, ne sera pas décrit ici en détail.

Le procédé de l'invention consiste alors à mettre en oeuvre, dans l'ordinateur 1, un logiciel 12 de contrôle de cohérence, enregistré dans la mémoire 2. Ce logiciel permet de contrôler la cohérence entre les symboles de chaque planche, à partir du contenu du fichier 11 de précodage de la planche correspondante.

Le logiciel de contrôle 12 utilise un catalogue de références 13, enregistré dans la mémoire 2, pour vérifier à partir du contenu du fichier de précodage 11 de chaque planche, la cohérence des attributs des symboles de cette planche et la cohérence des variables d'entrée-sortie des éléments fonctionnels correspondant respectivement à ces symboles. Si une incohérence est détectée dans une planche, et qu'elle est créée par un mauvais choix de symbole, celui-ci peut être changé. Si c'est une variable d'entrée-sortie de la planche qui crée l'incohérence, celle-ci est alors modifiée. Il y a donc interactivité entre la détection d'une incohérence dans une planche et la correction rendue nécessaire par la détection de cette incohérence. Il en résulte que chaque planche visualisée peut être corrigée dès qu'une incohérence est détectée, et que le fichier de précodage peut être corrigé lors d'une traduction ultérieure.

Le logiciel de contrôle de cohérence interne à chaque planche ne sera pas décrit ici en détail. En effet, différents logiciels capables de réaliser ce type de contrôle peuvent être mis en oeuvre pour parvenir au même résultat.

Ce contrôle étant effectué, deux fichiers 14A, 14B sont enregistrés pour chaque planche, dans la mémoire 2. Un fichier 14A est relatif aux attributs des symboles de la planche, pour lesquels la cohérence vient d'être vérifiée, ces symboles ayant été éventuellement modifiés de manière interactive à la suite de la détection d'une incohérence. Un autre fichier 14B est relatif aux variables d'entrée-sortie de la planche elle-même.

Le procédé de l'invention consiste ensuite à mettre en oeuvre dans l'ordinateur 1 un logiciel 15, enregistré dans la mémoire 2, pour contrôler la cohérence de l'enchaînement temporel de l'ordre d'exécution et des conditions d'exécution des planches d'un module, à partir du contenu des fichiers 11 de précodage des planches de ce module décrivant cet enchaînement. Ce logiciel permet de vérifier que l'ordre temporel dans lequel se déroule l'exécution des planches est respecté et que les conditions d'exécution sont elles aussi respectées. En effet, il peut exister pour certaines planches des choix conditionnels d'exécution, qui doivent être respectés.

Si une incohérence est détectée dans l'ordre ou les conditions d'exécution des planches, une correction interactive doit être effectuée. Si cette incohérence provient d'un symbole ou d'une variable d'entrée-sortie d'un symbole ou d'une planche, ce symbole ou cette variable est immédiatement corrigé de manière interactive, de sorte que le fichier de précodage 11 de chaque planche et/ou les fichiers 14A, 14B relatifs aux attributs et variables des symboles de chaque planche, sont automatiquement corrigés et ainsi tenus à jour.

Le logiciel 15 de contrôle de cohérence d'enchaînement temporel de l'ordre et des conditions d'exécution des planches n'est pas décrit ici en détail. En effet, différents logiciels capables de réaliser ce type de contrôle peuvent être mis en oeuvre pour parvenir au même résultat.

Lorsque la cohérence d'enchaînement temporel des planches a été contrôlée, et que les corrections éventuelles ont été effectuées, un fichier unique 16 de précodage des planches de l'enchaînement est enregistré dans la mémoire 2. Ce fichier est mis à jour dès qu'une correction intervient dans une planche. Ce fichier unique contient les attributs et les variables d'entrée-sortie de tous les symboles des planches de l'enchaînement après correction.

Le procédé consiste alors après ces contrôles, à enregistrer pour chaque module, dans la mémoire 2, un dictionnaire 17 de mise à jour des planches de ce module. Ce dictionnaire est mis à jour à partir des contenus des fichiers 14A, 14B relatifs aux attributs et variables des symboles de chaque planche, et du contenu du fichier unique 16 de précodage des planches de l'enchaînement. Ce dictionnaire mis à jour périodiquement après chaque session de corrections résultant des contrôles de cohérence, contient les attributs des symboles de chaque planche et les variables d'entrée-sortie de chaque planche.

Enfin, le procédé consiste à fournir le logiciel en code source, modélisant le module, à partir des fichiers 14 et 16 résultant des contrôles de cohérence de chaque planche et de l'ensemble des planches, et à partir du contenu du dictionnaire 17 et du catalogue de références 13. Ce logiciel en code source est fourni par traitement des contenus des fichiers 14A, 14B, 16, et du contenu du dictionnaire 17, par un logiciel de traitement 18 enregistré dans la mémoire 2. Il permet de constituer dans la mémoire 2 des fichiers 19 modélisant les planches du module, en code source. Ce code est disponible sur une sortie 20 des fichiers 19.

L'ordinateur 1 est relié au réseau de communications 4, par exemple pour transmettre le logiciel ainsi obtenu à un système de simulation, ou pour recevoir d'une autre station, reliée au réseau, des planches mises en mémoire dans un autre ordinateur.

## Revendications

1. Procédé interactif de production de logiciels en code source, modélisant des ensembles complexes de modules fonctionnels, consistant pour chaque module :
- à mettre en oeuvre dans un ordinateur (1) relié à des moyens de visualisation (3), un logiciel (6) d'édition graphique enregistré dans une mémoire (2) reliée à l'ordinateur, pour élaborer des planches graphiques (7) décrivant des asservissements et/ou des circuits logiques complexes intervenant dans le module, ce logiciel élaborant lesdites planches pour leur affichage par les moyens de visualisation (3), à partir d'une bibliothèque (8) de symboles graphiques enregistrée dans ladite mémoire (2) et permettant de décrire lesdits asservissements et/ou circuits logiques ;
- à mettre en oeuvre dans l'ordinateur (1), un logiciel (9) de précodage, enregistré dans la mémoire (2) de l'ordinateur pour définir chaque symbole d'une planche (7) par un précode comportant au moins des attributs du symbole et des variables d'entrée-sortie de ce symbole, à partir d'une bibliothèque (10) de précodes enregistrée dans la mémoire (2) de l'ordinateur, un fichier (11) de précodage étant alors enregistré dans la mémoire de l'ordinateur, pour chaque planche ;
caractérisé en ce qu'il consiste en outre :
- à mettre en oeuvre dans l'ordinateur (1), un logiciel (12) de contrôle de cohérence entre les symboles de chaque planche, enregistré dans la mémoire (13), ce logiciel utilisant un catalogue de références enregistrées dans la mémoire, pour vérifier pour chaque planche, à partir du fichier de précodage (11), la cohérence des attributs des symboles et la cohérence des variables d'entrée-sortie de ces symboles, et pour enregistrer après vérification et corrections éventuelles, pour chaque planche, un fichier (14A) relatif aux attributs des symboles de la planche et un fichier (14B) relatif aux variables d'entrée-sortie de cette planche ;
- à mettre en oeuvre dans l'ordinateur (1), un logiciel (15) pour contrôler la cohérence de l'enchaînement temporel de l'ordre d'exécution et des conditions d'exécution des planches d'un module, à partir du contenu du fichier (11) de précodage des planches spécifiques de ce module et appartenant à cet enchaînement, et pour enregistrer un fichier unique (16) de précodage des planches de cet enchaînement ;
- à enregistrer dans la mémoire de l'ordinateur, pour chaque module, un dictionnaire (17) de contrôle de mise à jour des planches de ce module, à partir du contenu des fichiers (14A, 14B, 16) relatif aux attributs et aux variables des symboles de chaque planche et du contenu du fichier unique de précodage des planches de l'enchaînement, ce dictionnaire (17) contenant les attributs des symboles de chaque planche et les variables d'entrée-sortie de chaque planche, et étant mis à jour après toute modification d'un symbole d'une planche ;
- à produire le logiciel en code source, modélisant le module à partir d'un logiciel (18) de traitement des contenus des fichiers (14A, 14B, 16) de précodage des attributs et des variables des symboles de chaque planche, du contenu du fichier unique de précodage, et du contenu du dictionnaire (17).

2. Procédé selon la revendication 1, caractérisé en ce qu'il consiste à modéliser des ensembles complexes de modules de commandes électriques ou automatiques de vol d'un avion.

## Patentansprüche

1. Interaktives Verfahren zur Erzeugung von Quellcode-Software, das komplexe Mengen von funktionalen Modulen modelliert, für jeden Modul darin bestehend:
- in einem Computer mit Anzeigeeinrichtungen (3) eine Graphikaufbereitungs-Software (6) zu benutzen, abgespeichert in einem mit dem Computer verbundenen Speicher (2), um Graphiktafeln (7) zu erstellen, die Regelungen bzw. Steuerungen und/oder komplexe logische Schaltungen beschreiben, die sich in dem Modul auswirken, wobei diese Software die genannten, zur Sichtbarmachung auf den Anzeigeeinrichtungen (3) bestimmten Tafeln aufgrund einer in dem genannten Speicher (2) abgespeicherten Graphiksymbole-Bibliothek (8) erstellt und ermöglicht, die genannten Regelungen bzw. Steuerungen und/oder logischen Schaltungen zu beschreiben;
- in dem Computer (1) eine in dem Speicher (2) des Computers abgespeicherte Vorcodierungs-Software (9) zu benutzen, um aufgrund einer in dem Speicher (2) des Computer abgespeicherten Vorcode-Bibliothek (10) jedes Symbol einer Tafel (7) durch einen Vorcode zu definieren, der wenigstens Attribute des Symbols und Eingabe-/Ausgabe-Variablen dieses Symbols umfaßt, wobei dann für jede Tafel eine Vorcodierungsdatei (11) in dem Speicher des Computers abgespeichert wird;
**dadurch gekennzeichnet**, daß es außerdem darin besteht:
- in dem Computer (1) eine Software (12) zur Kontrolle der Kohärenz zwischen den Symbolen jeder Tafel zu benutzen, abgespeichert in dem Speicher (13), wobei diese Software einen Katalog von in dem Speicher abgespeicherten Referenzen bzw. Bezugspunkten benutzt, um bei jeder Tafel aufgrund der Vorcodierungsdatei (11) die Kohärenz der Attribute der Symbole und die Kohärenz der Eingabe-/Ausgabe-Variablen dieser Symbole zu überprüfen und um nach Überprüfung und eventueller Korrektur für jede Tafel eine die Attribute der Symbole der Tafel betreffende Datei (14A) und eine die Eingabe-/Ausgabe-Variablen dieser Tafel betreffende Datei (14B) abzuspeichern;
- in dem Computer (1) eine Software (15) zu benutzen, um die Kohärenz der zeitlichen Verkettung bzw. Verknüpfung des Ausführungsbefehls und der Ausführungsbedingungen der Tafeln eines Moduls aufgrund des Inhalts der Vorcodierungsdatei (11) der spezifischen und zu dieser Verknüpfung gehörenden Tafeln dieses Moduls zu kontrollieren, und um eine einzige Vorcodierungsdatei (16) der Tafeln dieser Verknüpfung abzuspeichern;
- in dem Speicher des Computers für jeden Modul ein Kontrollverzeichnis (17) abzuspeichern, zur Aktualisierung der Tafeln dieses Moduls aufgrund des Inhalts der die Attribute und die Variablen der Symbole jeder Tafel betreffenden Dateien (14A, 14B, 16) und des Inhalts der einzigen Vorcodierungsdatei der Verknüpfungstafeln, wobei dieses Verzeichnis (17) die Attribute der Symbole jeder Tafel und die Eingangs-/Ausgangs-Variablen jeder Tafel enthält und nach jeder Änderung eines Symbols einer Tafel aktualisiert wird;
- die Quellcode-Software zu erzeugen, die den Modul aufgrund einer Software (18) zur Verarbeitung der Inhalte der Speicher (14A, 14B, 16) der Vorcodierung der Attribute und der Variablen der Symbole jeder Tafel, des Inhalts der einzigen Vorcodierungsdatei und des Inhalts des Verzeichnisses (17) modelliert.

2. Verfahren nach Anspruch 1, dadurch gekennzeichnet, daß es darin besteht, komplexe Mengen elektrischer oder automatischer Flugsteuerungsmodule eines Flugzeugs zu modellieren.

## Claims

1. Interactive source-code software production method modelling complex sets of functional modules and consisting for each module of:
- implementing in a computer (1) connected to a display means (3) a graphic editing software (6) stored in a memory (2) connected to the computer so as to embody graphic plates (7) describing automatic controls and/or complex logic circuits occurring in the module, this software elaborating said plates for the attributes of the latter to be displayed by the display means (3) from a library (8) of graphic symbols stored in said memory (2) and making it possible to describe said automatic controls and/or logic circuits;
- implementing in the computer (1) a precoding software (9) stored in the memory (2) of the computer so as to define each symbol of a plate (7) by a precode comprising at least the attributes of the symbol and the input/output variables of this symbol from a library (10) of precodes stored in the memory (2) of the computer, a precoding file (11) then being stored in the memory of the computer for each plate,
characterized in that it further consists of:
- implementing in the computer (1) a software (12) for control of coherence between the symbols of each plate stored in the memory (13), this software making use of a catalogue of references stored in the memory so as to verify for each plate, on the basis of the precoding file (11), the coherence of the attributes of the symbols and that of the input/output variables of these symbols and, after verification and any possible corrections, to store for each plate a file (14A) relating to the attributes of the symbols of the plate and a file (14B) relating to the input/output variables of this plate;
- implementing in the computer (1) a software (15) to control coherence of the temporal order of execution and the execution conditions of the plates of a module on the basis of the contents of the file (11) for precoding specific plates of this module and belonging to this chaining, and to store a single file (16) for precoding the plates of this chaining;
- storing in the memory of the computer for each module a control dictionary (17) for updating the plates of this module from the contents of the files (14A, 14B, 16) relating to the attributes and variables of the symbols of each plate and from the contents of the sole file for precoding the plates of the chaining, this dictionary (17) containing the attributes of the symbols of each plate and the input/output variables of each plate and being updated after any modification of a symbol of a plate;
- producing the source-code software modelling the module from a software (18) for processing the contents of the files (14A, 14B, 16) for precoding the attributes and variables of the symbols of each plate, the contents of the sole precoding file and the contents of the dictionary (17).

2. Method according to claim 1, characterized in that it consists of modelling complex sets of modules with electric or automatic flight controls of an aircraft.
